# EUROPÄISCHE PATENTSCHRIFT

(11) **EP 0 573 623 B1**
(45) Veröffentlichungstag und Bekanntmachung des Hinweises auf die Patenterteilung: **05.03.1997**
(21) Anmeldenummer: 92923677.6
(22) Anmeldetag: 26.11.1992
(51) Int. Cl.: H03K 5/01, G01P 3/48

(54) **SCHALTUNGSANORDNUNG ZUR ERZEUGUNG EINER DREHZAHLABHÄNGIGEN SIGNALFOLGE**
CIRCUIT FOR GENERATING AN RPM-DEPENDENT SEQUENCE OF SIGNALS
CIRCUIT SERVANT A GENERER UNE SEQUENCE DE SIGNAUX EN FONCTION DE LA VITESSE DE ROTATION

(30) Priorität: 17.12.1991 DE 4141547
(43) Veröffentlichungstag der Anmeldung: 15.12.1993
(73) Patentinhaber: ROBERT BOSCH GMBH, 70442 Stuttgart (DE)
(72) Erfinder: SCHMITZ-HUEBSCCH, Axel, D-71686 Remseck (DE); URSCHEL, Patrick, 67657 Kaiserslautern (DE)
(86) Internationale Anmeldenummer: DE9200984
(87) Internationale Veröffentlichungsnummer: WO9312579

(56) Entgegenhaltungen:
- WO-A-83/00193
- DE-A- 3 918 409
- DE-C- 3 225 800
- PATENT ABSTRACTS OF JAPAN, Bd. 3, Nr. 85 (E-124)21. Juli 1979;& JP-A-5461863
- NUCLEAR INSTRUMENTS AND METHODS Bd. 190, Nr. 1, November 1981, AMSTERDAM,THE NETHERLANDS Seiten 67 - 70 BERNARD GOTTSCHALK 'TIMING DISCRIMINATOR USING
- LEADING-EDGE EXTRAPOLATION'

## Beschreibung

### Stand der Technik

Die Erfindung geht aus von einer Schaltungsanordnung zur Erzeugung einer drehzahlabhängigen Signalfolge aus einem von einem Sensor, beispielsweise einem induktiven Sensor gelieferten Ausgangssignal nach der Gattung des Hauptanspruchs.

Es ist bekannt, beispielsweise zur Steuerung der Zündung und Einspritzung bei Brennkraftmaschinen induktive Sensoren einzusetzen, mit deren Hilfe die Stellung der Kurbelwelle sowie die Drehzahl bestimmt wird. Weiterhin ist bekannt, daß die Höhe der in den induktiven Sensoren induzierten Spannung stark von der Geschwindigkeit der am Sensor vorbeilaufenden Teile, deren Geschwindigkeit zu messen ist, abhängt, so daß in einer nachfolgenden Auswerteschaltung, die üblicherweise eine Schwellwertstufe aufweist, Probleme auftreten, die unter dem Stichwort Eigenverstellung bekannt sind.

Daher wird, wie beispielsweise aus der EP-PS 0 083 594 bekannt ist, entweder der Schwellwert der Schwellwertstufe in Abhängigkeit von der Geschwindigkeit der zu messenden Anordnung bzw. der Drehzahl verändert, eine andere Möglichkeit, die aus derselben Druckschrift bekannt ist, besteht darin, das Sensorsignal selbst in Abhängigkeit von der Drehzahl und damit der Höhe der vom Sensor abgegebenen Spannung zu verschieben.

Die bekannten Auswerteschaltungen haben jedoch den Nachteil, daß trotz der Beeinflussung der Sensorspannung bzw. der Beeinflussung der Höhe des Schwellwerts der Schwellwertstufe die Gefahr besteht, daß Störimpulse zu Fehlerkennungen führen. Ein weiterer Nachteil ist die relativ hohe Ansprechschwelle (> 250 mV), die bei den bekannten Auswerteschaltungen benötigt wird.

Aus der DE-OS 39 18 409 ist eine Schaltungsanordnung zur Erzeugung einer drehzahlabhängigen Signalfolge bekannt, mit der die Ausgangssignale eines induktiven Sensors ausgewertet werden, wobei aus den erhaltenen Informationen die Zündung einer Brennkraftmaschine gesteuert werden soll. Die bekannte Schaltungsanordnung umfaßt mehrere Schwellwertschalter, deren Schaltschwelle in Abhängigkeit von der Amplitude des vom Induktivsensor gelieferten Signales verstellt wird. Es sind weiterhin logische Mittel, beispielsweise Flip-Flops, vorgesehen, denen die Ausgangssignale der beiden Schwellwertstufen zugeführt werden, wobei am Ausgang der durch die beiden Flip-Flops gebildeten logischen Schaitung ein charakteristisches Synchronisationssignal entsteht.

### Vorteile der Erfindung

Die erfindungsgemäße Schaltungsanordnung mit den kennzeichnenden Merkmalen des Anspruchs 1 hat demgegenüber den Vorteil, daß durch den Einsatz eines oder mehrerer Differenzverstärker sowie durch die amplitudengesteuerte Hystereseumschaltung eine Störimpulsunabhängige Auswertung (bzgl. Gleichtaktstörimpulsen) der Ausgangssignale eines Induktivsensors gewährleistet ist und daß keine Eigenverstellung auftritt.

Weiterhin ermöglicht die beanspruchte Schaltungsanordnung eine besonders gute und vorteilhafte Gleichtaktunterdrückung. Ein weiterer Vorteil ist der potentialfreie, Eingang der Schaltungsanordnung, der durch Verwendung des Differenzverstärkers realisiert wird. Ein weiterer Vorteil ist die niedrige Ansprechschwelle (50 mV), die auch bei kleinen Drehzahlen eine Auswertung erlaubt.

Durch den Einsatz zusätzlicher Schaltungselemente, beispielsweise zweier Stromquellen, die einen Kondensator aufladen sowie eines Zeitverzögerungsgliedes, über welches das aufbereitete Sensorsignal geführt wird, wird eine weitere Erhöhung der Störfestigkeit der Auswerteschaltung erzielt.

Besonders vorteilhaft ist, daß die erfindungsgemäße Schaltungsanordnung universell einsetzbar ist, da durch externe Dimensionierung eines Kondensators und eines Widerstandes eine Anpassung an die jeweiligen Erfordernisse möglich ist.

### Zeichnung

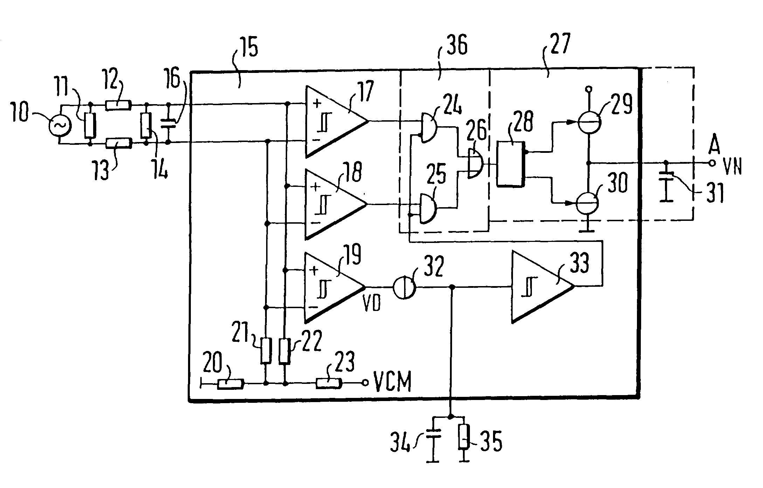

Die Erfindung ist in der Zeichnung dargestellt und wird in der nachfolgenden Beschreibung näher erläutert. Dabei zeigt die Figur ein mögliches Ausführungsbeispiel der erfindungsgmäßen Auswerteschaltung.

### Beschreibung

In der einzigen Figur ist ein Ausführungsbeispiel der Erfindung dargestellt, bei dem ein Induktivsensor 10 über eine Widerstandskombination 11, 12, 13, 14 mit zwei Eingängen der Schaltung 15 verbunden ist, wobei zwischen diesen beiden Eingängen noch ein Kondensator 16 angeordnet ist.

Die Schaltung 15 umfaßt im einzelnen drei Komparatoren 17, 18 und 19, deren Eingänge über die Widerstände 12 oder 13 mit dem Sensor 10 verbunden sind und zuätzlich über ein Widerstandsnetzwerk 20, 21, 22, 23 zwischen eine Spannung VCM, die etwa der halben Versorgungsspannung entspricht, und Masse gelegt sind.

Die Ausgänge der Komparatoren 17 und 18 sind mit je einem Eingang der UND-Gatter 24, 25 verbunden, deren Ausgang mit je einem Eingang eines ODER-Gatters 26 verbunden ist.

An das ODER-Gatter 26 schließt sich eine Schaltungsgruppe zur Störunterdrückung 27 an, die im einzelnen aus einem Zeitverzögerungsglied 28 und zwei Stromquellen 29, 30 sowie einem Kondensator 31 besteht.

Dabei liegen die Stromquellen 29, 30 zwischen der Spannung VD und Masse und jede der Stromquellen 29, 30 ist mit einem Ausgang des Zeitverzögerungsgliedes 28 verbunden. Die Verbindung zwischen den Stromquellen 29 und 30 liegt über den Kondensator 31 auf Masse und führt außerdem zum Ausgang A, an dem das aufbereitete Nutzsignal VN abgegriffen werden kann, das die gewünschte drehzahlabhängige Signalfolge darstellt.

Der Ausgang des Komparators 19 ist über eine Stromqelle 32 mit einer Schwellwertstufe 32 verbunden, deren Ausgang auf je einen Eingang der UND-Gatter 24, 25 führt. Weiterhin ist die Stromquelle 32 bzw. der Eingang der Schwellwertstufe 33 mit einem externen Kondensator 34 sowie einem externen Widerstand 35 so verbunden, daß der Kondensator 34 und der Widerstand 35 zueinander parallel geschaltet sind.

Die Widerstände 11, 12, 13 und 14 sowie der Kondensator 16 dienen als Eingangsbeschaltung, dabei begrenzen die Widerstände 12 und 13 den Strom in die Eingänge der Komparatoren 17, 18, 19. Der Widerstand R14 ist nicht unbedingt erforderlich, er ist nötig, wenn die untere Ansprechempfindlichkeit höher gelegt werden soll. Der Widerstand 11 bedämpft den durch die Geberinduktivität und die parasitären Leitungskapazitäten gebildeten Schwingkreis.

Der Kondensator 16 dient zur Verbesserung der Störfestigkeit und bildet mit den Widerständen 12 und 14 ein Tiefpaßfilter. Die Widerstände 20, 21, 22 und 23 gewährleisten einen potentialfreien hochohmigen Eingang der nachfolgenden Verstärkeranordnung, außerdem legen sie einen Spannungspegel von VCM/2 am Eingang der Komparatoren 17, 18, 19 fest, entsprechend dem Arbeitspunkt des Eingangssignals.

Das Ausgangssignal des Induktivgebers 10, aus dem die drehzahlabhängige Signalfolge gebildet werden soll, liegt parallel an den Komparatoren 17, 18, 19, die vorzugsweise als Operationsverstärker bzw. Differenzverstärker ausgestaltet sind. Diese Operationsverstärker weisen eine unterschiedliche Hysterese auf, wobei der Komparator 17 eine Hysterese von plus/minus 50mV aufweist, Komparator 18 plus/minus 750mV und Komparator 19 plus/minus 1,0V.

Die am Ausgang des Komparators 19 auftretende Differenzspannung VD bestimmt die Einschaltdauer der Stromquelle 32, die ihrerseits den externen Kondensator 34 auflädt. Je nach Einschaltdauer wird damit der Kondensator 34 unterschiedlich hoch aufgeladen. Abhängig vom Potential, das sich damit am Eingang der Schwellwertstufe 33 einstellt, schaltet die Schwellwertstufe 33, so daß ihr Ausgang entweder einen High-Zustand oder einen Low-Zustand aufweist.

Da der Ausgang des Schwellwertschalters 33 mit je einem Eingang der UND-Gatter 24, 25 verbunden ist und der jeweils andere Eingang dieser UND-Gatter entweder mit dem Komparator 17 oder dem Komparator 18 verbunden ist, schaltet je nach Zustand des Ausgangs des Schwellwertschalters entweder das UND-Gatter 24 oder das UND-Gatter 25 durch und leitet somit entweder das Ausgangssingal des Komparators 17 oder das des Komparators 18 zum ODER-Gatter 26 weiter. Damit bilden die Elemente 33, 24, 25 und 26 eine logische Einrichtung, die sicherstellt, daß abhängig vom Potential am Eingang des Schwellwertschalters 33 eine Signalauswertung über Komparator 17 oder 18 erfolgt.

Da die Komparatoren 17 und 18 eine unterschiedliche Hysterese aufweisen, wird damit die gewünschte, umschaltbare Hysterese erhalten.

Der externe Kondensator 34 bzw. der zu ihm parallel liegende Widerstand 35 legen das Potential am Eingang des Schwellwertschalters 33 fest, eine geeignete Dimensionierung dieser Bauelemente kann ohne Einflußnahme auf die übrigen Schaltungsteile erfolgen, so daß die Schaltung 15 einheitlich für alle Fahrzeuge ausgestaltet sein kann und die Anpassung lediglich über den Kondensator 34 und den Widerstand 35 erfolgen kann. Diese beiden Bauelemente sind ausserhalb der Schaltung 15 angeordnet und daher ohne Beeinflussung der Schaltung 15 zugängig. Die Schaltung 15 ist vorzugsweise in einem Chip integriert.

Die Schaltungsanordnung zur Störunterdrückung 27 ermöglicht die Unterdrückung von Störimpulsen bis zu 20 us. Länge. Das Zeitverzögerungsglied 28 läßt Störimpulse mit einer Dauer von weniger als 20 us nicht zum Ausgang gelangen und die beiden Stromquellen 29 und 30 ermöglichen im Zusammenspiel mit dem Kondensator 31 eine weitere, variable Störunterdrückung.

## Patentansprüche

1. Schaltungsanordnung zur Erzeugung einer drehzahlabhängigen Signalfolge aus einem von einem Sensor, vorzugsweise einem induktiven Sensor gelieferten Ausgangssignal, insbesondere zur Steuerung der Zündung und/oder Einspritzung einer Brennkraftmaschine mit einem ersten (17), einem zweiten (18) und einem dritten (19) Schaltmittel, die mit dem Sensor in Verbindung stehen, mit einem vierten (33) Schaltmittel des dem dritten Schaltmittel (19) nachgeschaltet ist, wobei die Ausgänge der ersten Schaltmittel (17), (18), (33) über eine Logik (36) mit dem Ausgang (A), an dem die drehzahlabhängige Signalfolge bereitgestellt wird, verbindbar sind und die ersten (17), zweiten (18) und dritten (19) Schaltmittel jeweils einen als Differenzverstärker aufgebauten Komparator umfassen, wobei die Komparatoren parallel zueinander geschaltet sind und unterschiedliche Schalthysterese aufweisen, dadurch gekennzeichnet, daß die Logik zwei UND-Gatter umfaßt, deren jeweils einer Eingang mit einem der ersten und zweiten Schaltmittel (17), (18) und deren anderer Eingang mit dem vierten Schaltmittel (33) in Verbindung steht und deren Ausgänge mit den Eingängen eines ODER-Gatters in Verbindung stehen.

2. Schaltungsanordnung nach Anspruch 1, dadurch gekennzeichnet, daß die Logik (36) in Abhängigkeit von der Höhe des Ausgangssignals des Sensors (10) eines der ersten und zweiten Schaltmittel (17), (18) mit dem Ausgang (A) der Schaltungsanordnung verbindet.

3. Schaltungsanordnung nach einem der vorhergehenden Ansprüche, dadurch gekennzeichnet, daß zwischen dem Sensor (10) und den ersten, zweiten und dritten Schaltmitteln (17), (18) und (19) ein erstes Widerstandsnetzwerk (11), (12), (13), (14) und ein Kondensator (16) liegt und/oder ein zweites Widerstandsnetzwerk(20), (21), (22), (23), das hochohmig ist und die Eingänge der ersten, zweiten und dritten Schaltmittel (17), (18), (19) symmetrisch um die Spannung VCM legt.

4. Schaltungsanordnung nach einem der vorhergehenden Ansprüche, dadurch gekennzeichnet, daß Speichermittel (32,34,35) zur Beeinflussung der vierten Schaltmittel vorgesehen sind, die mit dem Ausgang der dritten Schaltmittel (19) in Verbindung stehen und über eine Stromquelle (32) aufladbar sind, deren Einschaltdauer in Abhängigkeit vom Ausgangssignal des Sensors (10) veränderbar ist.

5. Schaltungsanordnung nach Anspruch 4, dadurch gekennzeichnet, daß die Speichermittel einen Kondensator (34) und einen parallel zu diesem liegenden Widerstand (35) umfassen, die auch außerhalb der übrigen Schaltungsanordnung liegen.

6. Schaltungsanordnung nach einem der vorhergehenden Ansprüche, dadurch gekennzeichnet, daß zwischen der Logik (36) und dem Ausgang (A) eine Schaltungsanordnung zur Störimpulsunterdrückung (27) liegt.

7. Schaltungsanordnung nach Anspruch 6, dadurch gekennzeichnet, daß die Schaltungsanordnung zur Störimpulsunterdrückung (27) ein Zeitverzögerungsglied (28), das mit zwei Stromquellen (29), (30) in Verbindung steht, die ihrerseits mit einem Kondensator in Verbindung stehen, umfaßt.

## Claims

1. Circuit arrangement for generating a rotational speed-dependent signal sequence from an output signal supplied by a sensor, preferably an inductive sensor, in particular for controlling the ignition and/or injection of an internal combustion engine, having a first (17), a second (18) and a third (19) switching means which are connected to the sensor, having a fourth (33) switching means which is connected downstream of the third switching means (19), it being possible to connect the outputs of the first switching means (17), (18), (33) via a logic arrangement (36) to the output (A) at which the rotational speed-dependent signal sequence is provided, and the first (17), second (18) and third (19) switching means each comprising a comparator which is constructed as a differential amplifier, the comparators being connected in parallel with one another and having different switching hysteresis, characterized in that the logic arrangement comprises two AND gates, one input of which is respectively connected to one of the first and second switching means (17), (18) and the other input of which is connected to the fourth switching means (33) and the outputs of which are connected to the inputs of an OR gate.

2. Circuit arrangement according to Claim 1, characterized in that the logic arrangement (36) connects one of the first and second switching means (17), (18) to the output (A) of the circuit arrangement as a function of the level of the output signal of the sensor (10).

3. Circuit arrangement according to one of the preceding claims, characterized in that there is connected between the sensor (10) and the first, second and third switching means (17), (18) and (19) a first resistor network (11), (12), (13), (14) and a capacitor (16), and/or a second resistor network (20), (21), (22) (23), which has a high impedance and balances the inputs of the first, second and third switching means (17), (18), (19) symmetrically about the voltage VCM.

4. Circuit arrangement according to one of the preceding claims, characterized in that there are provided storage means (32, 34, 35) for influencing the fourth switching means, which are connected to the output of the third switching means (19) and can be charged via a current source (32), the turned-on duration of which can be varied as a function of the output signal of the sensor (10).

5. Circuit arrangement according to Claim 4, characterized in that the storage means comprise a capacitor (34) and a resistor (35) connected in parallel therewith, said capacitor and resistor also being situated outside the remaining circuit arrangement.

6. Circuit arrangement according to one of the preceding claims, characterized in that a circuit arrangement for interference pulse suppression (27) is connected between the logic arrangement (36) and the output (A).

7. Circuit arrangement according to Claim 6, characterized in that the circuit arrangement for interference pulse suppression (27) comprises a time delay element (28) which is connected to two current sources (29), (30), which are in turn connected to a capacitor.

## Revendications

1. Circuit pour générer une séquence de signaux dépendant de la vitesse de rotation à partir d'un signal de sortie fourni par un capteur de préférence un capteur inductif, notamment pour commander l'allumage et/ou l'injection d'un moteur à combustion interne, comprenant un premier (17), un second (18) et un troisième (19) moyen de commutation coopérant avec le capteur, ainsi qu'un quatrième moyen de commutation (33) en aval du troisième moyen de commutation (19), dans lequel règnent les sorties des premiers moyens de commutation (17, 18, 33) peuvent être reliés par une logique (36) à la sortie (A) fournissant la séquence de signaux dépendant de la vitesse de rotation, et les premiers (17), second (18), troisième (19) moyens de commutation comprennent chaque fois un comparateur en forme d'amplificateur différentiel, les comparateurs étant branchés en parallèle et possèdent des hystérésis de commutation différentes,
caractérisé en ce que
la logique comprend deux portes ET dont une entrée est reliée chaque fois au premier et second moyen de commutation (17, 18) et l'autre entrée est reliée au quatrième moyen de commutation (33), les sorties étant reliées aux entrées d'une porte OU.

2. Circuit selon la revendication 1,
caractérisé en ce que
la logique (36) relie en fonction de l'amplitude du signal de sortie du capteur (10) l'un du premier et second moyen de commutation (17, 18) à la sortie (A) du dispositif de commutation.

3. Dispositif selon l'une quelconque des revendications précédentes,
caractérisé en ce qu'
entre le capteur (10) et le premier, le second et le troisième moyen de commutation (17, 18, 19) on un premier réseau de résistances (11, 12, 13, 14) et un condensateur (16) et/ou un second réseau de résistances (20, 21, 22) fortement ohmique, et les entrées du premier, second et troisième moyen de commutation (17, 18, 19) sont symétriques autour de la tension (VCM).

4. Circuit selon l'une des revendications précédentes,
caractérisé par
des moyens de mémoire (32, 34, 35) pour influencer le quatrième moyen de commutation, ces moyens état reliés à la sortie du troisième moyen de commutation (19) et pouvant être chargés par une source de courant (32) dont la durée de branchement est variable en fonction du signal de sortie du capteur (10).

5. Circuit selon la revendication 4,
caractérisé en ce que
les éléments de mémoire comprennent un condensateur (34) et en parallèle à celui-ci, une résistance (35). Ces deux composants étant à l'extérieur du circuit.

6. Circuit selon l'une des revendications précédentes,
caractérisé par
un dispositif de commutation entre la logique 36 et la sortie (A) pour supprimer les impulsions parasites (27).

7. Circuit selon la revendication 6,
caractérisé en ce que
le circuit pour supprimer les impulsions parasites (27) comprend un élément de temporisation (28) relié à deux sources de courant (29, 30) elles-mêmes reliées à un condensateur.
